# EUROPÄISCHE PATENTSCHRIFT

(11) **EP 0 588 180 B1**
(45) Veröffentlichungstag und Bekanntmachung des Hinweises auf die Patenterteilung: **06.03.1996**
(21) Anmeldenummer: 93114121.2
(22) Anmeldetag: 03.09.1993
(51) Int. Cl.: C09J 7/02

(54) **Verwendung eines Selbstklebebandes zum vorübergehenden Fixieren von Wafern (Dicing Tape)**
Use of a self-adhesive tape for temporarily fixing wafers (dicing tape)
Utilisation d'un film auto-adhésif pour la fixation temporaire de wafers (dicing tape)

(30) Priorität: 15.09.1992 DE 4230784
(43) Veröffentlichungstag der Anmeldung: 23.03.1994
(73) Patentinhaber: Beiersdorf Aktiengesellschaft, D-20245 Hamburg (DE)
(72) Erfinder: Spies, Manfred, Dr., D-20251 Hamburg (DE); Harder, Christian, Dr., D-22589 Hamburg (DE); Guse, Günter, Dr., D-21077 Hamburg (DE); Feldt, Claudia, D-22525 Hamburg (DE); Meyer, Robert, D-22529 Hamburg (DE)

(56) Entgegenhaltungen:
- DE-A- 2 743 979
- GB-A- 2 184 741
- US-A- 4 968 559

## Beschreibung

Die Erfindung betrifft die Verwendung eines Selbstklebebandes (Dicing Tape) zum vorübergehenden Fixieren von Wafern.

Bevor bei der Chip-Herstellung die einzelnen Schaltelemente und Leiterzüge auf dem Wafer erzeugt werden können, muß der Wafer zunächst sehr eben sein. Dieses erreicht man durch Schleifen. Hierbei ist eine Fixierung und ein Schutz nötig, wie ihn ein sog. Dicing Tape bietet. Darauf haftend wird der so vorbehandelte Wafer bestimmten Prozessen unterworfen, um die eigentlichen Schaltelemente und Leiterzüge zu kreuzen. Bei diesen Prozessen handelt es sich vorwiegend um photolithographische Prozesse. Im Anschluß daran wird der vorbehandelte Wafer zersägt, um die einzelnen Chips zu erhalten. Auch für den Sägevorgang muß der Wafer fixiert werden, in der Regel mit jenem Dicing Tape, das zu Beginn eine bestimmte Ausgangsklebkraft hat, die nach erfolgtem Sägevorgang gezielt abgesenkt wird, um die Chips zu vereinzeln. Bei kleinen Chips erfolgt die Vereinzelung durch rückseitiges Anstechen mit einem Dorn und anschließendes Abheben mit einem Saugstempel. Bei größeren Bauelementen versagt dieses Verfahren, da die Chips zerbrechen können. Hier ist ein Dicing Tape notwendig, bei dem die Klebkraft nach dem Sägen gezielt absenkbar sein muß, so daß das Anstechen mit einem Dorn entfällt.

Derartige Dicing Tapes sind bereits bekannt. So beschreibt die **EP-OS 157.508** ein dünnes Selbstklebeband, das bei der Bearbeitung von Halbleiter-Wafern eingesetzt werden soll und das in der Klebmasse einen nachträglich zugemischten Photosensibilisator enthält. Die Klebkraft dieses Bandes mit aufgeklebten Wafern läßt sich durch Dehnen und UV-Bestrahlung so reduzieren, daß die Wafer mit entsprechenden Greifern/Saugrüsseln wieder von dem Band abgenommen werden können.

Auch aus der **EP-OS 298.448** ist ein solches strahlungs-vernetzbares Selbstklebeband bekannt, bei dem in der Klebmasse Cyanurate und Isocyanurate verwendet werden, um die UV-Vernetzung und damit die erwünschte Klebkraft-Depression zu verbessern.

Es sind auch bereits Selbstklebebänder aus der **DE-PS 2.743.979** bekannt, die eine vernetzte Polyacrylat-Klebmasse aufweisen, welche einen Photoinitiator einpolymerisiert enthält, um die Klebmasse nach Beschichten auf den Klebeband-Träger in gezielter Weise durch UV-Strahlung zu vernetzen, in den Zustand einer weitmaschigen, gegen Nachvernetzung stabilen Kettenverknüpfung, wie sie für Selbstklebemassen typisch ist (Sp.2, Z.23-28).

Produkte dieses Standes der Technik weisen jedoch für den vorgesehenen Zweck der Wafer-Bearbeitung schwerwiegende Nachteile auf.

Wafer werden als Halbleiter für elektronische Anwendungen aus Materialien von außerordentlicher Reinheit hergestellt. Für diese gelten spezifische Anforderungen, die es erforderlich machen, diese mit größter Vorsicht zu behandeln, nicht nur mechanisch sondern auch chemisch. Bei jedem Kontakt mit Fremdmaterialien ist darauf zu achten, daß keinerlei niedermolekulare, migrationsfähige Bestandteile auf oder in den Wafer übergehen können. Derartige Verunreinigungen würden seinen Gebrauch beschränken oder gar unmöglich machen. Dazu kommen toxikologische Bedenken beim Arbeiten mit entsprechenden Klebmassen, da an entsprechend hochspezialisierten Arbeitsplätzen täglich und über lange Zeit mit diesen Materialien umzugehen ist.

Anregungen für die hier vorgesehene Anwendung konnten aber auch nicht aus der DE-PS 2.743.979 erhalten werden, da dort gerade durch die vorgesehene UV-Bestrahlung typische Selbstklebemassen erst geschaffen werden sollten (Sp.2, Z.23-28), während es sich hier darum handelt, eine drastische Depression der Klebkraft zu erzielen, wie eben ein Dicing Tape mit einem typischen Selbstklebeband nicht vergleichbar ist. Die Selbstklebemassen gemäß DE-PS 2.743.979 lassen sich zudem durch Bestrahlung nicht entkleben. Sie erreichen viel mehr einen Grenzwert der Vernetzung, der auch durch längeres Bestrahlen nicht überschritten wird. Die Klebrigkeit bleibt dabei nahezu unverändert erhalten.

Gelöst wird die gestellte Aufgabe mit der Verwendung eines Dicing Tapes, wie dies in den Ansprüchen näher gekennzeichnet ist.

Damit werden Vorteile bei der Bearbeitung von Wafern erzielt, die den Fachmann überraschen. Durch den kovalenten Einbau der Photosensibilisatoren in Selbstklebemassen entsteht bereits während der Copolymerisation ein homogenes Produkt, das die Fertigung des erfindungsgemäßen Dicing Tapes erlaubt. Dadurch ist auch die gewünschte Vernetzung, die zur Klebkraftdepression führt, besonders gleichmäßig und effizient. Dieses gilt auch für den Fall, daß Folien mit mäßiger Strahlungstransparenz verwandt werden. Zudem kann das Klebkraft-profil gezielt eingestellt werden, vor und nach Vernetzung, sowohl durch die Monomeren-Kombination als auch durch die Strahlungs-lntensität und -Dauer. Dieses Klebkraft-Profil wird vorteilhaft bestimmt durch den gezielten Einbau von kristallinen bzw. amorphen Polymersegmenten im Copolymer. Mit besonderem Vorteil werden langkettige Acrylsäureester wie z.B. Stearylacrylat verwendet, dessen Seitenkettenkristallinität besonders zu den Klebeigenschaften beiträgt. Ein nachträglicher Zusatz von reaktiven und toxischen niedermolekularen Verbindungen für die Vernetzung ist nicht nur unnötig, sondern wird im Interesse der Reinhaltung des Wafers bewußt vermieden.

Als Trägermaterialien sind sowohl die üblichen halogenhaltigen Folien wie z.B. PVC einsetzbar, als auch halogenfreie Folien, die aus ökologischen Aspekten deutliche Vorteile bieten. Die Folien können sowohl einschichtig, als auch mehrschichtig laminiert, vorzugsweise jedoch einschichtig sein. Aufgrund des selektiven Charakters der UV-Initiatoren ist der Einbau bestimmter UV-Filter in das Foliensystem überflüssig.

Als Trägermaterialien kommen alle UV-durchlässigen Folien in Betracht, die sowohl aus Homopolymeren als auch aus Copolymeren aufgebaut sein können, wie beispielsweise Polyethylen, Polypropylen, PVC, Polyester oder Ethylenvinylacetat-Copolymere, vorzugsweise Folien mit einem hohen elastischen Anteil, wie Weich-PVC und Polybuten oder 1,2-Polybutadien oder Ethylbutylacrylat-Copolymere als halogenfreie Varianten. Bestimmte Weich-PVC und Ethylbutylacrylat-Copolymer Typen bieten den Vorteil, daß Dehnungen bis zu 800% gleichmäßig in X und Z-Richtung zu realisieren sind. Die Dicken der Folien liegen insbesondere zwischen 5 und 400 mm, vorzugsweise zwischen 20 und 80 mm. Die Verwendung eines Ethylbutylacrylatcopolymeren als Trägermaterial in Kombination mit einem Polyacrylatcopolymeren als Klebemasse erwies sich als besonders günstig im Hinblick auf die Verankerung der Klebemasse.

Die Polymerisation kann mit allen handelsüblichen Initiatorsystemen durchgeführt werden, insbesondere mit radikalischen, wie Peroxide, Azoverbindungen und Dicarbonate, z.B. Benzoylperoxid, Ditertiärbutylperoxid, Diamylperoxid, Azobisisobutyronitril, 2,2'-Azobis-(2-methylbutyronitril), Bis(4-t-butylcyclohexyl)peroxidicarbonat, Diacetylperoxidicarbonat. Besonders bevorzugt ist Dibenzoylperoxid.

Diese Verbindungen können sowohl alleine als auch als Mischungen eingesetzt werden.

Die Klebkraft-depression vor dem Entfernen des durchgesägten Chips von dem Dicing Tape erfolgt durch UV-Bestrahlung. Die verwendeten UV-Sensibilisatoren sind dabei Verbindungen, bei denen die UV-sensiblen Gruppen an polymerisierbare Einheiten gebunden sind. Beispiele hierfür sind 2-Propensäure-(2-oxo-1,2-diphenyl-ethyl)-ester (Benzoinacrylat) und 4-(2-Acryloyloxyethoxy)-phenyl-(2-hydroxy-2-propyl)-keton, bevorzugt ist Benzoinacrylat. Diese Photosensibilisatoren werden insbesondere in Mengen von 0,1-5 Gew.-%, vorzugsweise 1-3 Gew.--% eingesetzt.

Auch diese Verbindungen können sowohl alleine, als auch als Mischung eingesetzt werden.

Geeignete Monomere für die Synthese des Klebstoffsystems sind Acrylsäure und Acrylsäureester vom Typ H₂C=CR₁-CO-OR₂, mit folgenden Bedeutungen R₁ = H _{oder} -CH₃, R₂ = C1-C24 mit linearen und verzweigten Kohlenstoffketten in der Estereinheit, Ethyldiglykol, 4-t-Butylcyclohexyl, 2-Hydroxyethyl, Hydroxypropyl, Hydroxybutyl, Dimethylaminoethyl, vorzugsweise n-Butyl bis Stearyl.

Entsprechende Varianten auf der Basis von Methacrylsäure und Methacrylsäureestern sind ebenfalls geeignet.

Auch Vinylacetat und diverse Vinylalkylether vom Typ

H₂C=CH-O-R

mit
R = Methyl, Ethyl, Propyl, Isobutyl, Octadecyl, Cyclohexyl, 4-Hydroxybutyl sind einsetzbar, ebenso Vinylpyrrolidon, Vinylcaprolactam, Vinylcarbazol und 1-Vinylimidazol.

### Beispiel

### Polymerisatherstellung:

In einer 2-Liter-Polymerisationsapparatur aus Glas oder Stahl, ausgerüstet mit Rührer, Rückflußkühler, Thermometer, und Gaseinleitungsrohr, wurden 192 g 2-Ethylhexylacrylat, 200 g Stearylacrylat, 8 g Benzoinacrylat und 266 g Aceton vorgelegt. Die Lösung wurde zunächst unter Rühren (ca. 120 U/min.) durch Spülen mit Stickstoff vom Sauerstoff befreit und dann zum Sieden erhitzt.

Durch portionsweise Zugabe von insgesamt 0,4 Gew.-% Dibenzoylperoxid wurde die Polymerisation ausgelöst und weitergeführt. Während der Polymerisationszeit von etwa 20 Stunden wurde in Abhängigkeit von der Viskosität mehrmals mit Lösungsmittel (Benzin 60/95) verdünnt, so daß die fertige Polymerlösung einen Feststoffgehalt von 30 - 60 Gew.-% aufwies.
Ausbeute [%]: 99,4
K-Wert []: 83,1

### Beschichtung:

Die oben beschriebene Polymerlösung wurde wie folgt weiter verwendet.

Träger: EBA-Folie, 70 mm Dicke.

### 1. Arbeitsgang

Einseitige Corona-Vorbehandlung zur Verbesserung der Masseverankerung mit 1,85 kW bei 10 m/min. (entspricht ca. 38 mN/m)

### 2. Arbeitsgang

Möglichst frühzeitig nach der Corona-Behandlung erfolgte die Massebeschichtung auf dieser vorbehandelten Seite (Geschwindigkeit: 1 m/min; Massegewicht: ca. 10 - 15 g/m, Trocknung in sechs Zonen: 60/70/70/80/80/90°C). Das beschichtete Tape wurde mit Trennfolie/Trennpapier abgedeckt.

### 3. Arbeitsgang

Das fertige Tape wurde folienträgerseitig einer ES-Bestrahlung unterzogen (170 kV und 4-5 m/min Geschwindigkeit, um eine Dosis von ca. 10 kGy zu erzielen), um das Eigenschaftsprofil der Folie und die Verankerung der Klebemasse zu verbessern.

### Produkteigenschaften:

Das auf die oben geschilderte Weise hergestellte Dicing Tape weist eine Anfangsklebkraft auf einem Siliziumwafer von 1,1 N/cm auf.

Nach der UV-Bestrahlung (stationär; 30 sec Hanau Q 1200) sinkt die Klebkraft des Musters auf 0,15 N/cm.

Für die Bestrahlung wurden handelsübliche UV-Bestrahlungsquellen eingesetzt. Nach der üblichen Methode des Dehnens des Bandes mit darauf geklebten Wafern und UV-Bestrahlen wie beschrieben, lassen sich die Wafer problemlos und unbeschädigt abnehmen.

### Prüfmethoden:

### K-Wert:

Der K-Wert wurde nach den üblichen Methoden der Kapillarviskosimetrie (in Ubbelohde-Viskosimetern) bestimmt. Die Messungen wurden an Lösungen von 1 g Polymer in 100 ml Toluol bei 25°C durchgeführt.

### Klebkraft:

Die rauhe Seite der Wafer-Oberfläche (nicht polierte Seite) wurde mit dem unbestrahlten Prüfstreifen (Breite: 20 mm) beklebt. Die Applikation erfolgte luftblasenfrei. Im Anschluß wurde das Tape manuell vorsichtig angedrückt. Die Messung erfolgte mit einer elektronischen Zugprüfmaschine innerhalb einer Minute nach Applikation (Abzugswinkel: 180°C, Abzugsgeschwindigkeit: 300 mm/min).

## Patentansprüche

1. Verwendung eines Selbstklebebandes (Dicing Tape) zum vorübergehenden Fixieren von Wafern, wobei ein durch UV-Strahlung partiell entklebendes Selbstklebeband (Dicing Tape) mit einem Träger aus einer UV-Strahlungs-durchlässigen Folie und einer UV-strahlungs-vernetzbaren Selbstklebemasse eingesetzt wird, und wobei die polymere Selbstklebemasse UV-Strahlungs-Sensibilisatoren copolymerisiert enthält.

2. Verwendung nach Anspruch 1, dadurch gekennzeichnet, daß der copolymerisierte Sensibilisator Benzoinacrylat ist.

3. Verwendung nach Anspruch 1, dadurch gekennzeichnet daß die Träger-Folie aus Weich-PVC, Polybuten, 1,2-Polybutadien oder Ethylbutylacrylat-Copolymer besteht.

4. Verwendung nach Anspruch 1, dadurch gekennzeichnet, daß die Träger-Folie in beiden Richtungen ihrer Ebene dehnbar ist, bei einer Folienstärke von 5 - 400 mm, insbesondere 20 - 80 mm.

5. Verwendung nach Anspruch 1, dadurch gekennzeichnet, daß die Träger-Folie ein Ethylbutylacrylat-Copolymer und die Selbstklebemasse ein Polyacrylat-Copolymer ist.

6. Verwendung nach Anspruch 1, dadurch gekennzeichnet, daß die Selbstklebemasse ein Polyacrylat-Copolymer mit Seitenketten-Kristallinität ist.

## Claims

1. Use of a self-adhesive tape (dicing tape) for the temporary fixing of wafers, employing a self-adhesive tape which can be partially detackified by UV radiation (dicing tape) with a support comprising a UV-radiation-permeable film and a UV-radiation-crosslinkable self-adhesive composition, the polymeric self-adhesive composition comprising UV-radiation sensitizers in copolymerized form.

2. Use according to Claim 1, characterized in that the copolymerized sensitizer is benzoin acrylate.

3. Use according to Claim 1, characterized in that the support film consists of flexible PVC, polybutene, 1,2-polybutadiene or ethyl butyl acrylate copolymer [sic].

4. Use according to Claim 1, characterized in that the support film can be extended in both of its planar directions at a film thickness of 5 - 400 mm, especially 20 - 80 mm.

5. Use according to Claim 1, characterized in that the support film is an ethyl butyl acrylate copolymer [sic] and the self-adhesive composition is a polyacrylate copolymer.

6. Use according to Claim 1, characterized in that the self-adhesive composition is a polyacrylate copolymer with side-chain crystallinity.

## Revendications

1. Utilisation d'un ruban autoadhésif (ruban à découper) pour la fixation temporaire de plaquettes, pour laquelle il est fait usage d'un ruban autoadhésif (ruban à découper) partiellement décollé par irradiation U.V. comprenant un support formé d'une feuille perméable au rayonnement U.V. et une masse autoadhésive réticulable par irradiation U.V., et pour laquelle, la masse autoadhésive polymère contient à l'état copolymérisé des sensibilisateurs à l'irradiation U.V.

2. Utilisation suivant la revendication 1, caractérisée en ce que le sensibilisateur copolymérisé est l'acrylate de benzoyle.

3. Utilisation suivant la revendication 1, caractérisée en ce que la feuille de support consiste en PVC souple, en polybutène, en 1,2-polybutadiène ou en un copolymère d'acrylate d'éthyle et de butyle.

4. Utilisation suivant la revendication 1, caractérisée en ce que la feuille de support est susceptible d'allongement dans les deux directions de son plan pour une épaisseur de la feuille de 5 à 400 µm, en particulier de 20 à 80 µm.

5. Utilisation suivant la revendication 1, caractérisée en ce que la feuille de support est un copolymère d'acrylate d'éthyle et de butyle et la masse autoadhésive est un copolymère polyacrylique.

6. Utilisation suivant la revendication 1, caractérisée en ce que la masse autoadhésive est un copolymère polyacrylique présentant de la cristallinité en chaîne latérale.
